# EUROPEAN PATENT APPLICATION

(11) **EP 4 672 860 A1**
(43) Date of publication of application: **31.12.2025**
(21) Application number: 24868481.3
(22) Date of filing: 12.08.2024
(51) Int. Cl.: H05B 6/12, H05B 6/06, F24C 15/34, F24C 15/10, F24C 3/12, H02M 1/10, G01R 22/06

(54) **COOKING APPARATUS**

(30) Priority: 21.09.2023 KR 20230126657; 21.09.2023 KR 20230126658; 26.09.2023 KR 20230129154; 26.09.2023 KR 20230129155; 22.02.2024 KR 20240026117
(71) Applicant: LG ELECTRONICS INC., Yeongdeungpo-gu Seoul 07336 (KR)
(72) Inventor: HAN, Hyeong Gu, Seoul 08592 (KR); KANG, Kyelyong, Seoul 08592 (KR); HAN, Jinwook, Seoul 08592 (KR); JEONG, Sihoon, Seoul 08592 (KR)
(74) Representative: Ter Meer Steinmeister & Partner
(86) International application number: PCT/KR2024/011966
(87) International publication number: WO 2025/063502

(57) **Abstract**

Disclosed is a cooking apparatus in which the power of a load can be measured using a resonance current obtained by performing current conversion on a driving current supplied to the load. The cooking apparatus includes: a heating coil; a drive circuit for supplying a driving current to the heating coil according to a switching operation and outputting a resonance current and a resonance voltage obtained by performing current conversion on the driving current; a current measurement circuit for measuring the average input current of the heating coil using the resonance current and the resonance voltage; and a controller for measuring the power of the heating coil using the average input current, determining the switching frequency of the drive circuit on the basis of the measured power, and controlling the switching operation on the basis of the switching frequency.

## Description

### TECHNICAL FIELD

The present disclosure relates to a cooking appliance, and more particularly, to a cooking appliance including an induction heating cooktop.

### BACKGROUND ART

Recently, an induction range using induction heating technology is attracting attention as a next-generation cooking appliance that may replace a gas range due to advantages such as high heating efficiency, fast heating speed, stability, convenience, etc.

An induction heating cooktop product includes an induction heating cooktop having a heating coil composed of a ritz wire. When an induction-compatible container is located at a predetermined burner position, the container is heated. This scheme has a disadvantage in that the container should be placed only at a predetermined position, and has a disadvantage in that heating efficiency decreases when the position of the container is slightly incorrect.

Accordingly, all-free induction heating technology is being developed. This is a technology capable of heating the induction-compatible container even when the induction-compatible container is positioned not only at a predetermined area of an induction heating top plate but also at various positions thereof, and has the advantage that various sized containers and a multiple-compartment container having three or more compartments may also be heated.

When a multi-burner is constructed, a PCB pattern heating coil has advantages of mass production, ease in design modification, and a cost. However, the PCB pattern heating coil has a smaller equivalent resistance (Req) and a smaller equivalent inductance (Leq) compared to the ritz wire heating coil. Therefore, an inverter circuit should be capable of operating at a high frequency. For this reason, the inverter circuit employs a SiC switch having a small switching loss even when the inverter circuit operates at the high frequency.

However, a conventional induction heating cooking appliance measures power using a shunt resistor subsequent to a DC capacitor. Such a shunt resistor-based power measurement scheme has a problem in that the reliability of operation and desaturation protection (DESAT) function of the SiC switch is lowered due to noise of a shunt ground terminal.

### SUMMARY OF DISCLOSURE

### TECHNICAL PURPOSE

A purpose of the present disclosure is to provide a cooking appliance capable of measuring power of a load based on a resonant current obtained via current conversion of a driving current to be supplied to the load.

In addition, a purpose of the present disclosure is to provide a cooking appliance capable of measuring power of a heating coil based on a resonant current obtained via current conversion of a driving current and an offset current.

In addition, a purpose of the present disclosure is to provide a cooking appliance capable of measuring power of a heating coil based on a multiplying result between a resonant current obtained via current conversion of a driving current and a resonant voltage.

In addition, a purpose of the present disclosure is to provide a cooking appliance which processes the resonant current into a direct current type input current and averages the input current and measures power of a heating coil based on the average input current.

In addition, a purpose of the present disclosure is to provide a cooking appliance capable of improving reliability of the switching operation and desaturation protection (DESAT) function of an inverter circuit.

The purposes to be achieved according to an embodiment of the present disclosure are not limited to the above-mentioned purposes, and other purposes not mentioned will be clearly understood by those skilled in the art from the following description.

### TECHNICAL SOLUTION

The cooking appliance according to an embodiment of the present disclosure measures the power of the heating coil based on the resonant current obtained by converting a driving current.

Specifically, the cooking appliance measures an average input current of the heating coil based on the resonant current obtained via current conversion of the driving current to be supplied to the heating coil, and measures power of the heating coil based on the average input current.

In addition, the cooking appliance according to an embodiment of the present disclosure measures the power of the heating coil based on the resonant current obtained via current conversion of the driving current and an offset current.

Specifically, the cooking appliance adds the offset current to the resonant current obtained via current conversion of the driving current to be supplied to the heating coil, processes the resonant current into the direct current average input current using a switch switching according to the resonant voltage and a capacitor, and measures power of the heating coil based on the average input current.

In addition, the cooking appliance according to an embodiment of the present disclosure measures the power of the heating coil based on a multiplying result between the resonant current obtained via the current conversion of the driving current and the resonant voltage.

Specifically, the cooking appliance performs a multiplying result between the resonant current obtained via the current conversion of the driving current to be supplied to the heating coil and the resonant voltage to generate a DC (direct current) type input current having negative current and phase information, and averages the DC type input current, and measures the power of the heating coil based on the average input current.

In addition, the cooking appliance according to an embodiment of the present disclosure improves the reliability of the switching operation and DESAT function of the inverter circuit.

Specifically, the cooking appliance determines the switching frequency of the driving circuit based on the measured power of the heating coil, and controls the switching operation of the driving circuit based on the switching frequency.

A cooking appliance according to an embodiment of the present disclosure includes: a heating coil for heating a container using electromagnetic induction; a driving circuit configured to supply a driving current to the heating coil according to switching operation thereof, and to output a resonant current obtained via current conversion of the driving current, and a resonant voltage based on the driving current; a current measurement circuit configured to measure an average input current of the heating coil using the resonant current and the resonant voltage; and a controller configured to measure power of the heating coil using the average input current, determine a switching frequency of the driving circuit based on the measured power, and control the switching operation based on the switching frequency.

A cooking appliance according to another embodiment of the present disclosure includes: a load circuit including a heating coil; an inverter circuit configured to supply a driving current to the load circuit according to switching operation thereof; a current converter configured to perform current conversion of the driving current to output a resonant current; a resonant voltage generator configured to output a resonant voltage based on the driving current; a current measurement circuit configured to measure an average input current of the load circuit using the resonant current and the resonant voltage; and a controller configured to measure power of the load circuit using the average input current, determine a switching frequency of the driving circuit based on the measured power, and control the switching operation based on the switching frequency.

### TECHNICAL EFFECT

As described above, the cooking appliance of the present disclosure may measure the average input current using the resonant current obtained via the current conversion of the driving current to be supplied to the load, and may measure the power of the load based on the average input current.

In addition, the cooking appliance of the present disclosure may process the resonant current obtained via the current conversion of the driving current into the average input current in the form of the direct current using the offset current and the resonant voltage and may measure the power of the load based on the average input current.

In addition, the cooking appliance of the present disclosure may perform the multiplication between the resonant current obtained via the current conversion of the driving current and the resonant voltage to generate the input current having negative current and phase margin information, and may average the input current and may measure the power of the load based on the average input current.

In addition, the cooking appliance of the present disclosure may process the resonant current obtained via the current conversion of the driving current into the direct current type input current based on the offset current or the multiplier, and may average the input current to obtain the average input current, and measure the power of the load based on the average input current.

In addition, the cooking appliance of the present disclosure may determine the switching frequency of the inverter circuit based on the measured power of the load, and control the switching operation of the inverter circuit based on the switching frequency, thereby improving the reliability of the switching operation and the DESAT function of the inverter circuit.

In addition, the cooking appliance of the present disclosure may measure the power of the load based on the resonant current obtained via the current conversion of the driving current to be supplied to the heating coil, thereby preventing the influence of noise of the resistance of the ground voltage terminal.

In addition, the cooking appliance of the present disclosure may reduce the influence of the noise compared to the existing scheme of measuring the input current using the shunt resistor, thereby improving the reliability of the high frequency operation of the switching elements of the inverter circuit.

In addition, the cooking appliance of the present disclosure may accurately measure the power of the load based on whether the container is made of a ferromagnetic material or a paramagnetic material, and thus may switch the inverter circuit at an appropriate switching frequency based on the container material, thereby accurately driving the heating coil with the target power.

In addition to the above-described effects, specific effects of the present disclosure will be described together while describing specific matters for implementing the present disclosure.

### BRIEF DESCRIPTION OF DRAWINGS

FIG. 1 is an exploded perspective view illustrating an exploded state of a cooktop in a cooking appliance according to an embodiment of the present disclosure.
FIG. 2 is a plan view of the cooktop illustrated in FIG. 1 and a view illustrating a configuration of a PCB pattern coil assembly.
FIG. 3 is a view illustrating an arrangement structure of a heating coil and a sensing coil illustrated in FIG. 2.
FIG. 4 is a view illustrating a structure of a multi-layered sensing coil PCB in which the sensing coil illustrated in FIG. 2 is disposed.
FIG. 5 is a schematic block diagram illustrating power measurement in a cooking appliance according to an embodiment of the present disclosure.
FIG. 6 is a diagram illustrating a driving circuit having an inverter circuit in a cooking appliance according to an embodiment of the present disclosure.
FIG. 7 is a waveform diagram of a resonant current output from a current converter of FIG. 6.
FIG. 8 is a waveform diagram of a resonant voltage output from a resonant voltage generator of FIG. 6.
FIG. 9 is a diagram illustrating an offset-based current measurement circuit according to a first embodiment of the present disclosure.
FIG. 10 is a waveform diagram of a first node in the offset-based current measurement circuit of FIG. 9.
FIG. 11 is a waveform diagram of a second node in the offset-based current measurement circuit of FIG. 9.
FIG. 12 is a waveform diagram of a third node in the offset-based current measurement circuit of FIG. 9.
FIG. 13 is a diagram illustrating a multiplier-based current measurement circuit according to a second embodiment of the present disclosure.
FIG. 14 is a diagram illustrating a driving circuit and a load circuit in a cooking appliance according to an embodiment of the present disclosure.

### DETAILED DESCRIPTIONS

The above-described purposes, features, and advantages will be described in detail with reference to the accompanying drawings, and accordingly, a person having ordinary skill in the art to which the present disclosure pertains will be able to easily implement the technical idea of the present disclosure. In the description of the present disclosure, when it is determined that a detailed description of a known technology related to the present disclosure may unnecessarily obscure the gist of the present disclosure, the detailed description will be omitted. Hereinafter, preferred embodiments according to the present disclosure will be described in detail with reference to the accompanying drawings. In the drawings, the same reference numerals are used to indicate the same or similar components.

Although the first, second, and the like are used to describe various components, it is obvious that these components are not limited by these terms. These terms are used to distinguish only one component from another component. Unless otherwise stated, the first component may be the second component.

The present disclosure is not limited to the embodiments disclosed below, but various changes may be applied thereto and the present disclosure may be implemented in various different forms. However, the present embodiment is provided so that the present disclosure is complete and the scope of the present disclosure is fully informed to those skilled in the art. Therefore, the present disclosure is not limited to the embodiments disclosed below, but it should be understood that a configuration of one embodiment and a configuration of another embodiment are substituted with each other or are added to each other, and all changes, equivalents, and substitutes included in the technical spirit and scope of the present disclosure are included in the present disclosure.

The accompanying drawings are only set forth for easy understanding of the embodiments disclosed in the present disclosure, and the technical spirit disclosed in the present disclosure is not limited by the accompanying drawings, and it should be understood that all changes, equivalents, and substitutes included in the spirit and technical scope of the present disclosure are included in the present disclosure. In the drawings, the components may be expressed to be larger or smaller in size or thickness in consideration of convenience of understanding, etc. However, the scope of the present disclosure should not be limited thereto.

The terms used herein are used only to describe specific embodiments or embodiments, and are not intended to limit the present disclosure. As used herein, the singular constitutes "a" and "an" are intended to include the plural constitutes as well, unless the context clearly indicates otherwise In the present disclosure, terms such as "include" and "comprise" are intended to designate that a feature, a number, a step, an operation, a component, a part, or a combination thereof as described in the present disclosure exist. That is, it should be understood that in the present disclosure, the terms such as "include" and "comprise" do not exclude the presence or addition of one or more other features, numbers, steps, operations, components, parts, or combinations thereof.

Terms including ordinals, such as first, second, etc., may be used to describe various components, but the components are not limited by the terms. The terms are used only for the purpose of distinguishing one component from another component.

When it is mentioned that one component is "connected" or "coupled" to another component, it should be understood that one component may be directly connected or coupled to another component, or still another component may be present therebetween. On the other hand, when it is mentioned that one component is "directly connected" or "directly coupled" to another component, it should be understood that still another component is absent therebetween.

When one component is referred to as "being disposed on top of" or "being disposed under" another component, it should be understood that one component may be directly disposed on top of or under another component or still another component may be present therebetween.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

### [Overall Structure of Induction Heating Cooktop]

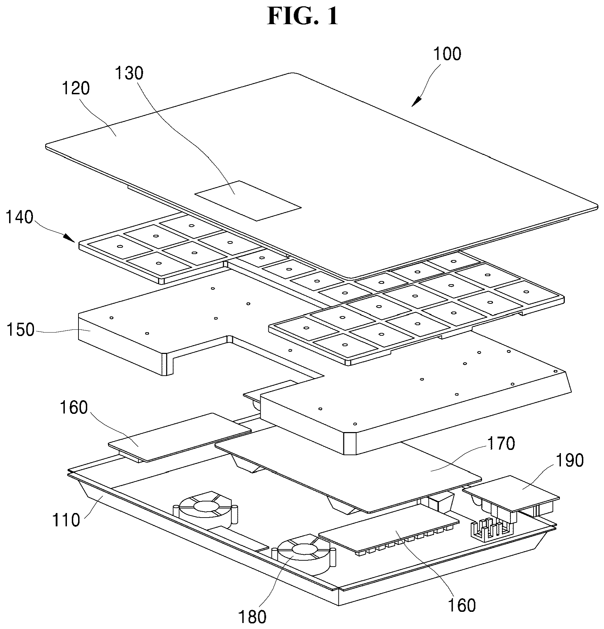

FIG. 1 is an exploded perspective view illustrating an exploded state of an induction heating cooktop 100 in a cooking appliance according to an embodiment of the present disclosure.

The cooking appliance according to an embodiment of the present disclosure may be an oven range type cooking appliance in which the cooktop 100 is disposed in an upper area and an oven is disposed in a lower area. The present disclosure is not limited thereto, and the cooking appliance according to an embodiment of the present disclosure may be embodied as a cooking appliance in which the cooktop 100 is provided alone.

Referring to FIG. 1, the cooking appliance according to an embodiment of the present disclosure includes the induction heating cooktop 100. The induction heating cooktop 100 may include a casing 110 and a top plate 120.

According to the present embodiment, an exterior of the cooktop 100 may be defined by the casing 110 and the top plate 120. The casing 110 may be disposed under the top plate 120, and may constitute a front surface, a rear surface, a side surface, and a bottom surface of the cooktop 100. The top plate 120 may be disposed at a top of the cooktop 100 and may constitute an outer appearance of an upper surface of the cooktop 100. The top plate 120 may be made of ceramic glass for mounting a cooking container thereon.

An accommodation space may be formed inside the casing 110. The accommodation space formed inside the casing 110 may be opened upwardly. In an example, the casing 110 may be formed in a hexahedral shape with an open upper side. In the accommodation space surrounded with the top plate 120 and the casing 110, various internal components constituting the cooktop 100 may be accommodated.

In addition, a PCB pattern coil assembly 140 may be disposed under the top plate 120 in the cooktop 100. In the PCB pattern coil assembly 140, at least one heating coil for heating the cooking container via induction heating and at least one sensing coil for sensing the cooking container may be integrally formed with each other.

For example, the PCB pattern coil assembly 140 may include a plurality of PCB pattern coil assemblies according to a size of the top plate 120 of the cooktop 100. For example, when the top plate 120 is divided into three areas including a left area, a central area, and a right area, three PCB pattern coil assemblies 140 may be respectively disposed under the corresponding areas. The PCB pattern coil assemblies 140 may be formed in different sizes to be suitable for the sizes of the left area, the central area, and the right area, respectively. Each of the PCB pattern coil assemblies 140 corresponding to each area may independently operate.

In the PCB pattern coil assembly 140, the heating coil for induction heating, the sensing coil for sensing the container, a temperature sensor for sensing a temperature, a terminal for connection with other components, etc. may be integrally formed with each other. The PCB pattern coil assembly 140 may be divided into a plurality of unit blocks. In an example, one heating coil may be disposed in one unit block. In an example, at least two sensing coils may be disposed in one unit block. In an example, two sensing coils may be disposed between adjacent unit blocks and across the two adjacent unit blocks.

In addition, in the cooktop 100, a supporter 150 may be disposed under the PCB pattern coil assembly 140. The supporter 150 may constitute a skeleton inside the cooktop 100 so as to support various internal components constituting the cooktop 100. In an example, the supporter 150 may be formed in a hexahedral shape with an open lower side. For example, the supporter 150 may be formed in a shape substantially identical with a shape obtained by turning the casing 110 upside down, and may be formed to have a slightly smaller size than that of the casing 110.

According to the present embodiment, the accommodation space may be formed inside the supporter 150, and may be formed as a space surrounded by the bottom portion of the casing 110 and the supporter 150. Various internal components constituting the cooktop 100 may be accommodated in the supporter 150.

For example, a resonant PCB assembly 160 in which capacitors used for resonance or oscillation are mounted, an inverter PCB assembly 170 in which a switching element for applying a current to the heating coil for induction heating, etc. are mounted, a fan 180 for cooling down the internal components, an EMI filter 190 for filtering and blocking various noises mixed with each other on electrical power, and a control PCB assembly in which a controller for controlling the overall operation of the cooktop 100 and circuits for sensing the cooking container are mounted may be accommodated in the supporter 190.

According to the present embodiment, the supporter 150 may also provide a base function for the PCB pattern coil assembly 140. More specifically, a ferrite core may be installed on an upper surface of the supporter 150, the PCB pattern coil assembly 140 may be installed on top of the ferrite core, and the top plate 120 may be installed on top of the PCB pattern coil assembly 140.

In addition, the cooktop 100 may include a control panel 130. The control panel 130 may be disposed on one area of an upper surface of the top plate 120. The control panel 130 may include a UI (user interface) including an adjustment icon for adjusting an operation of the cooktop 100 in a touch manner and a display for displaying an operation state of the cooktop 100.

### [PCB Pattern Coil Assembly]

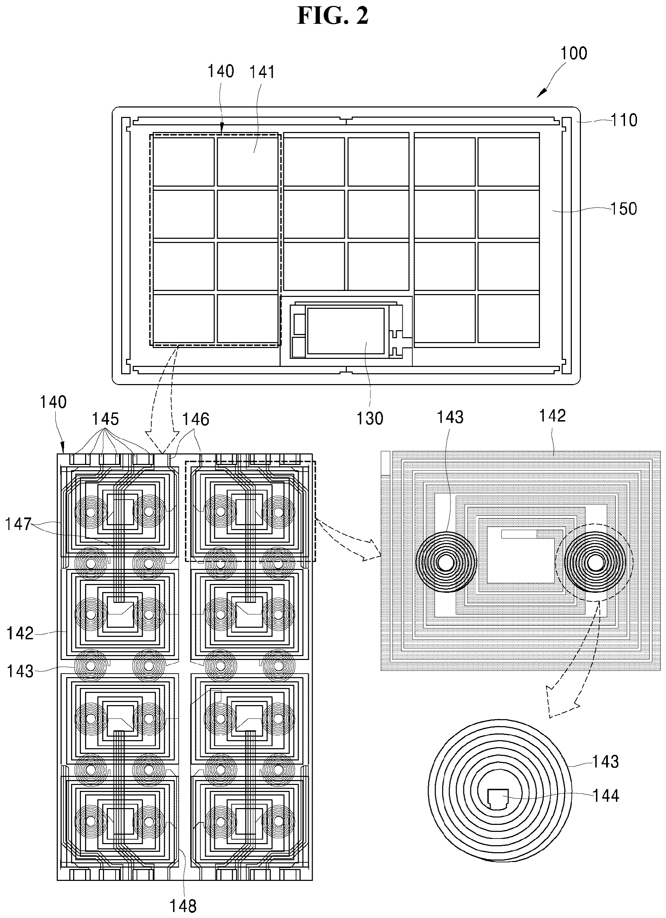

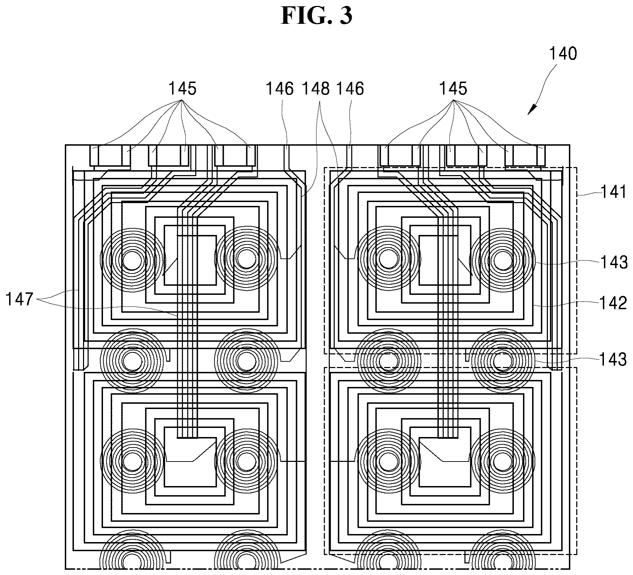

FIG. 2 is a plan view illustrating the cooktop 100 illustrated in FIG. 1 and a configuration of the PCB pattern coil assembly 140. FIG. 3 is a view illustrating an arrangement structure of a heating coil 142 and a sensing coil 143 illustrated in FIG. 2.

Referring to FIGS. 2 and 3, the cooktop 100 may include the casing 110, the supporter 150, and the PCB pattern coil assembly 140. The PCB pattern coil assembly 140 includes the heating coil 142 for induction heating of the cooktop 100 and the sensing coil 143 for sensing the cooking container, and may be disposed in the accommodation space inside the cooktop 100.

The supporter 150 may be disposed on top of the casing 110, the PCB pattern coil assembly 140 may be disposed on top of the supporter 150, and the top plate 120 may be disposed on top of the PCB pattern coil assembly 140.

The PCB pattern coil assembly 140 may include a plurality of PCB pattern coil assemblies according to the size and shape of the cooktop 100. In the present embodiment, it is illustrated that the cooktop 100 is divided into the left area, the central area, and the right area, and includes three PCB pattern coil assemblies 140 corresponding thereto. Each of the PCB pattern coil assemblies 140 may include a plurality of heating coils 142 and a plurality of sensing coils 143.

Each of the PCB pattern coil assemblies 140 may be divided into a plurality of unit blocks 141. The plurality of unit blocks 141 may be arranged in a matrix form. For example, at least one heating coil 142 may be disposed in one unit block 141. For example, at least two sensing coils 143 may be disposed in one unit block 141. In addition, at least two sensing coils 143 may be disposed between adjacent two unit blocks 141 and across the adjacent two unit blocks 141.

Each of the heating coil 142 and the sensing coil 143 formed in the PCB pattern coil assembly 140 may be disposed in a pattern form on a board. In an example, the heating coil 142 may be formed in a polygonal, for example, a square, a rectangular, or a hexagonal pattern. Alternatively, the heating coil 142 may be formed in an annular pattern. For example, the sensing coil 143 may be formed in a circular pattern. Alternatively, the sensing coil 143 may be formed in a circular, square, rectangular, or hexagonal pattern.

In addition, at least one heating coil terminal 145, at least one sensing coil terminal 146, at least one heating coil wiring 147, at least one sensing coil wiring 148, and at least one via may be formed in the PCB pattern coil assembly 140. The heating coil terminal 145 is electrically connected to the heating coil 142 via the heating coil wiring 147, and is electrically connected to the resonant PCB assembly 160 and the inverter PCB assembly 170. The sensing coil terminal 146 is electrically connected to the sensing coil 143 via the sensing coil wiring 148, and is electrically connected to the resonant PCB assembly 160 and the control PCB assembly.

As described above, not only the heating coil 142 but also the sensing coil 143 may be formed in the unit block 141 of the PCB pattern coil assembly 140. In the unit block 141, a plurality of sensing coils 143 are arranged along a front-rear direction, and a plurality of sensing coils 143 are also arranged in a lateral direction.

The PCB pattern coil assembly 140 may include a PCB (hereinafter, referred to as a "heating coil PCB") on which the heating coil 142 is patterned and a PCB (hereinafter, referred to as a "sensing coil PCB") on which the sensing coil 143 is patterned. The PCB pattern coil assembly 140 may be formed in a form in which the heating coil PCB and the sensing coil PCB are stacked in an up-down direction. In one example, the heating coil PCB may be formed in a form in which 10 to 12 layers are stacked, and the heating coils 142 of the layers may be electrically connected to each other via the via. In one example, the sensing coil PCB may be formed in a form in which two layers are stacked, and the sensing coils 143 of the layers may be electrically connected to each other via the via.

In addition, at least one of the heating coil PCB and the sensing coil PCB may be provided in a form in which the coil is patterned on each of both opposite surfaces of the board. In the present embodiment, it is illustrated that the heating coil 142 is patterned on each of both opposing surfaces of the heating coil PCB, and the sensing coil 143 is patterned on each of both opposing surfaces of the sensing coil PCB.

Each of the sensing coils 143 may be disposed to overlap an area where each of the heating coils 142 is formed, as shown in FIGS. 2 and 3. In addition, each of the sensing coils 143 may be disposed to overlap an area between two adjacent areas where the two heating coils 142 are formed, respectively.

In the present embodiment, it is illustrated that two sensing coils 143 are disposed in the area where each heating coil 142 is formed, and two sensing coils 143 are disposed between the two heating coils 142 adjacent to each other in the front-rear direction. In addition, a temperature sensor 144 may be provided in the PCB pattern coil assembly 140. In one example, the temperature sensor 144 may be disposed in a center portion of an area of each sensing coil 143.

In an example, the PCB pattern coil assembly 140 may be provided in a form in which the heating coil 142, the sensing coil 143, and the temperature sensor 144 are integrally formed with each other. For example, the PCB pattern coil assembly 140 may be formed in a form in which the heating coil PCB having the heating coil 142 and the sensing coil PCB having the sensing coil 143 and the temperature sensor 144 are stacked. The PCB pattern coil assembly 140 may be provided in a form including one or more pattern coil PCBs.

As described above, the PCB pattern coil assembly 140 has a structure in which a plurality of heating coils 142 for induction heating and a plurality of sensing coils 143 for sensing the cooking container mounted on the ceramic glass are integrally formed with each other using the patterns printed on the PCB. The number of heating coils 142 and sensing coils 143 may be determined based on the size of the cooktop 100.

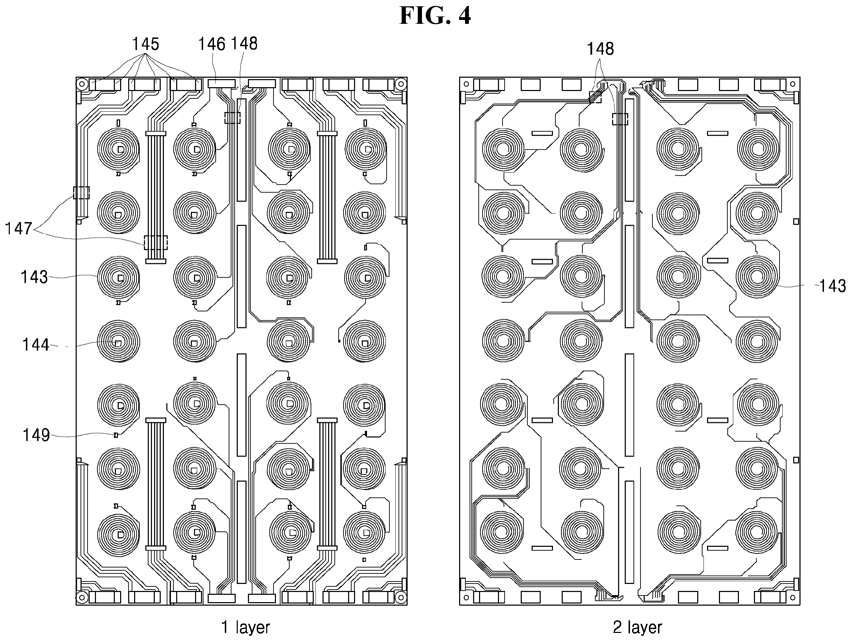

FIG. 4 is a view illustrating a multi-layered structure of sensing coil PCBs in which the sensing coil illustrated in FIG. 2 is disposed.

As shown in FIG. 4, the sensing coil PCBs may be stacked in a plurality of layers. In the present embodiment, a structure in which the sensing coil PCBs are stacked in two layers is illustrated.

A plurality of sensing coils 143 may be disposed in each layer of the sensing coil PCB. In an example, at least one heating coil terminal 145, at least one heating coil wiring 147, at least one sensing coil terminal 146, at least one sensing coil wiring 148, at least one via 149, and at least one temperature sensor 144 may be disposed in the sensing coil PCB of each layer.

The heating coil terminal 145 may be electrically connected to the heating coil wiring 147, and the heating coil wiring 147 may be electrically connected to the heating coil 142 of the heating coil PCB via the via. In addition, the sensing coil terminal 146 may be electrically connected to the sensing coil 143 via the sensing coil wiring 148, and the sensing coil 143 may be electrically connected to the sensing coil 143 of another layer via the via 149.

In this embodiment, the sensing coil 143 pattern may be printed on the PCB in a circular shape. Alternatively, the sensing coil 143 pattern may be printed on the PCB in a polygonal shape including a circular shape. The pattern of the sensing coil 143 may be composed of one layer or a plurality of layers of the entire PCB coil. When the pattern of the sensing coil 143 is composed of the plurality of layers, the sensing coils 143 of the layers may be electrically connected to each other via the via 149 of the PCB. In addition, the heating coil wiring 147 connected to the heating coil terminal 145 may be positioned in the layer of the sensing coil 143, and may be disposed separately from the heating coil 143.

As described above, in the PCB pattern coil assembly 140 in the present embodiment, when the heating coil 142 and the sensing coil 143 are constructed into an integrated structure composed of one component using a multilayer PCB board, the sensing coil 143 may be formed in a circular or polygonal shape using one or more layers.

The sensing coil 143 may be disposed between ones of the plurality of heating coils 142 adjacent to each other, or may be disposed on top of the heating coil 142. In addition, the sensing coils 143 may be arranged so as to be spaced from each other by an equal spacing in an upper-down direction and a left-right direction.

### [Configuration of Cooking Appliance for Power Measurement]

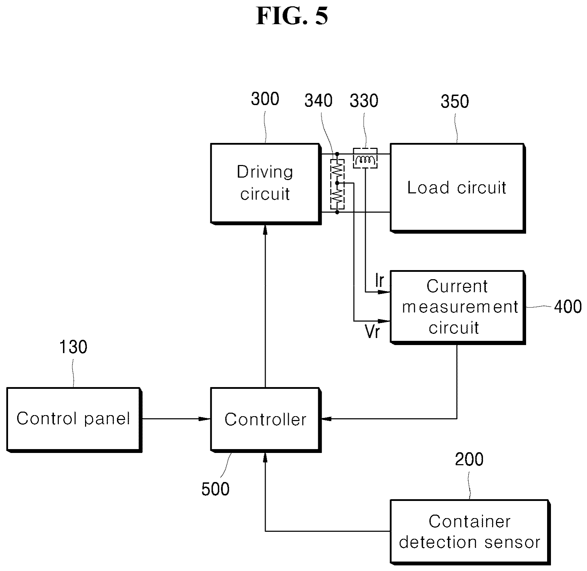

FIG. 5 is a schematic block diagram illustrating power measurement in a cooking appliance according to an embodiment of the present disclosure.

In an induction heating (IH) cooking appliance, an output load becomes an induction container due to the characteristics of the application thereof. The induction container is largely classified into a ferromagnetic material based container and a paramagnetic material-based container which have different characteristics. The cooking appliance has the container at a position of the heating coil and measures input power in an operation thereof and adjusts the output transmitted to the load via the inverter circuit based on the measurement result. The driving current transmitted to the load may be adjusted to be different from each other for the ferromagnetic material-based container and the paramagnetic material-based container.

Since the ferromagnetic material has a relatively large equivalent resistance and equivalent inductance under the same driving current condition, the cooking appliance may transmit higher power thereto as the load than the power applied to the paramagnetic material as the load.

Therefore, only when the driving current transferred from the cooking appliance to the load may be accurately measured, the heating coil may be accurately controlled using a target power suitable for the type of the material of the container.

Referring to FIG. 5, the cooking appliance according to an embodiment includes the control panel 130, a load circuit 350, a driving circuit 300, a container detection sensor 200, a current measurement circuit 400, and a controller 500.

The control panel 130 may be provided with a user interface including an adjustment icon for adjusting the operation of the cooking appliance in a touch manner and a display for displaying the operation state of the cooking appliance. The user may input a target heating intensity via the control panel 130.

The load circuit 350 includes at least one heating coil, at least one capacitor, and at least one relay. In this regard, the at least one heating coil, the at least one capacitor, and the at least one relay may be selectively connected in series or in parallel with each other.

The driving circuit 300 supplies the driving current to the load circuit 350 via switching operation of the inverter circuit. The driving circuit 300 may include a current converter 330 that generates a resonant current Ir obtained by converting the driving current based on the driving current, and a resonant voltage generator 340 that generates a resonant voltage Vr based on an AC voltage. The current converter 330 and the resonant voltage generator 340 may be provided inside the driving circuit 300 according to a design.

The current measurement circuit 400 may measure the input current to be applied to the load circuit 350 based on the resonant current Ir and the resonant voltage Vr, and may average the input current to measure the average input current.

The container detection sensor 200 detects the cooking container and provides a container detection signal according to the detection to the controller 500. The container detection sensor 200 stores oscillation energy in a detection coil 143 or outputs an oscillation signal that freely resonates under the control of the controller 500. The container detection sensor 200 filters the DC component from the oscillation signal, compares the filtered oscillation signal with a reference signal, and outputs the container detection signal according to the comparison result to the controller 500.

The controller 500 controls the driving circuit 300 to drive the load circuit 350 based on a target intensity received from the control panel 130. The controller 500 controls switching of the switching elements of the driving circuit 300.

The controller 500 measures the power of the load circuit 350 based on the average input current received from the current measurement circuit 400, determines a switching frequency so that a target heating intensity is maintained according to the power of the load circuit 350, and controls the switching operation of the inverter circuit of the driving circuit 300 based on the determined switching frequency.

The controller 500 determines container information including at least one of a position, a material, a shape, and a size of the container based on the container detection signal received from the container detection sensor 200. The controller 500 may control at least one relay in the load circuit 350 such that at least one heating coil corresponding to the position of the container is activated according to the position of the container.

The controller 500 may determine or vary a switching frequency for controlling the switching operation of the inverter circuit of the driving circuit 300 according to at least one of the material, shape, and size of the container.

### [Driving Circuit]

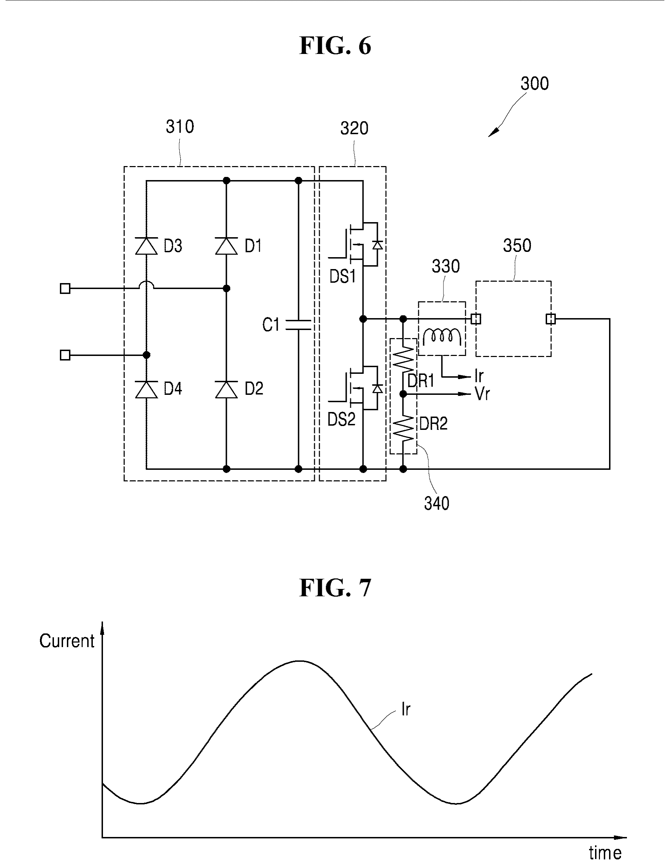

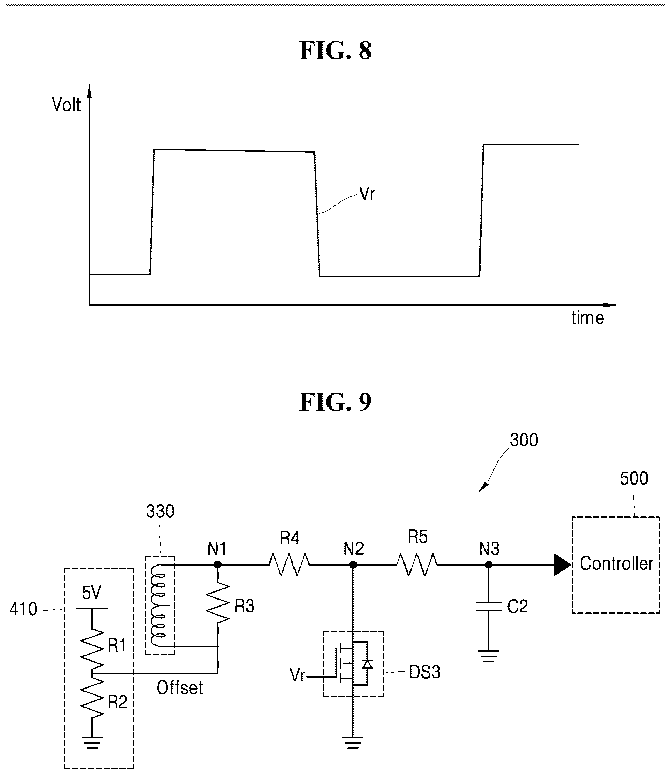

FIG. 6 is a diagram illustrating a driving circuit having an inverter circuit in a cooking appliance according to an embodiment of the present disclosure. FIG. 7 is a waveform diagram of a resonant current output from the current converter of FIG. 6. FIG. 8 is a waveform diagram of a resonant voltage output from the resonant voltage generator of FIG. 6.

Referring to FIG. 6, the driving circuit 300 includes a rectifier circuit 310 and an inverter circuit 320.

The rectifier circuit 310 converts AC power into DC power. Specifically, the rectifier circuit 310 converts an AC voltage of which a magnitude and polarity (positive voltage or negative voltage) change over time into a DC voltage of which a magnitude and polarity are constant, and converts an AC current of which a magnitude and a direction (positive current or negative current) change over time into a DC current of which a magnitude is constant.

The rectifier circuit 310 may include a bridge diode. Specifically, the rectifier circuit 310 includes four diodes D1, D2, D3, and D4. The diodes D1, D2, D3, and D4 constitute two diode pairs D1 and D2, and D3, and D4, the two diodes of each pair being connected in series with each other, and the two diode pairs D1 and D2, D3, and D4 are connected in parallel with each other. The bridge diode converts an AC voltage of which the polarity changes over time into a positive voltage having a constant polarity over time, and converts an AC current of which the direction changes over time into a positive current having a constant direction over time.

In addition, the rectifier circuit 310 includes a DC connection capacitor C1. The DC connection capacitor C1 converts a positive voltage whose magnitude changes over time into a DC voltage having a constant magnitude over time.

The inverter circuit 320 includes a switching circuit DS1 and DS2 that is configured to supply or block the driving current to the load circuit 350. The driving current may be supplied as an alternating current that resonates. The resonance frequency of the alternating current may be determined based on inductance of the heating coil and capacitance of the resonant capacitor.

The switching circuit DS1 and DS2 includes a first switch DS1 and a second switch DS2, and the first switch DS1 and the second switch DS2 are connected in series with each other and are disposed between a high potential voltage terminal and a low potential voltage terminal. The low-potential voltage terminal may be a ground voltage terminal. The first switch DS1 and the second switch DS2 are turned on or off according to the driving control signal of the controller 500. The driving current is output to the load circuit 350 via the first switch DS1 and/or the second switch DS2 according to the turn-on and turn-off of the first switch DS 1 and the second switch DS2.

The current converter 330 outputs the resonant current based on the driving current supplied from the inverter circuit 320 to the load circuit 350. The current converter 330 is disposed adjacent to an output line via which the driving current is output. In this regard, the output line is connected to and disposed between the load circuit 350 and a node between the first switch DS1 and the second switch DS2 of the inverter circuit 320. The current converter 330 adjacent to the output line converts the driving current to the resonant current having a magnitude proportional to a magnitude of the driving current. The resonant current Ir may resonate at a predetermined resonance frequency over time as shown in FIG. 7.

The resonant voltage generator 340 includes a first output resistor DR1 and a second output resistor DR2 connected in series with each other and disposed between and connected to the output line and the low potential terminal. The resonant voltage generator 340 outputs the resonant voltage Vr via a node between the first output resistor DR1 and the second output resistor DR2. As shown in FIG. 8, the resonant voltage Vr may be output in a form of a square wave according to the resonant driving current.

As such, the power measurement scheme according to the present embodiment is as shown in FIG. 6. In the present disclosure, the power is measured in an offset current-based or multiplier-based manner using the current converter 330 adjacent to the output line via which the driving current is output rather than in a power measurement manner using the shunt resistor. The power measurement scheme according to the present embodiment is a scheme of processing the resonant current into a form of the input current, and measuring the power to be transmitted to the load based on the average input current.

### [Current Measurement Circuit]

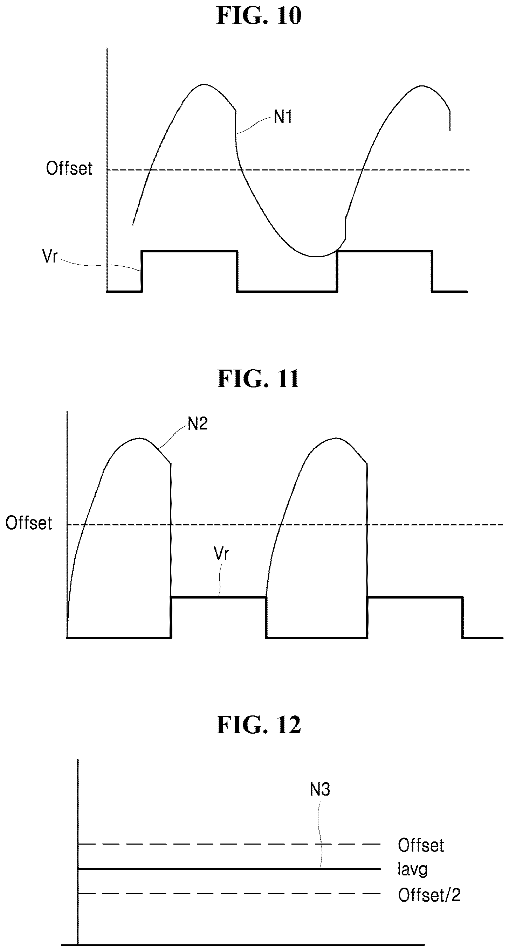

FIG. 9 is a diagram illustrating an offset-based current measurement circuit according to a first embodiment of the present disclosure. FIG. 10 is a waveform diagram of a first node in the offset-based current measurement circuit of FIG. 9. FIG. 11 is a waveform diagram of a second node in the offset-based current measurement circuit of FIG. 9. FIG. 12 is a waveform diagram of a third node in the offset-based current measurement circuit of FIG. 9.

FIG. 9 shows a circuit diagram of a circuit for offset current-based power measurement using current conversion. This circuit utilizes the resonant current and the resonant voltage in FIG. 6. The resonant current may be processed into the form of the direct current input current by taking an offset and then, performing switching using resonant voltage information. The DC input current may be averaged to be used to measure the power to be transmitted to the load.

Specifically, referring to FIGS. 9 to 12, the offset-based current measurement circuit 400 according to the first embodiment processes the resonant current Ir output from the current converter 330 into a direct current-type input current using an offset current.

The current measurement circuit 400 includes an offset circuit 410, a third switch DS3, and a capacitor C2. The offset circuit 410 of the current measurement circuit 400 includes a first resistor R1 and a second resistor R2 that are serially connected to each other and are disposed between and connected to the power voltage terminal and the ground voltage terminal.

The current measurement circuit 400 may further include a third resistor R3. The third resistor R3 is connected in parallel to the current converter 330, and one end thereof is connected to a node between the first resistor R1 and the second resistor R2 and the other end thereof is connected to a first node N1. The first node N1 may be defined as a node at which the resonant current and the offset current are added to each other.

The offset current is output from the node between the first resistor R1 and the second resistor R2 of the offset circuit 410. The offset current may be added to the resonant current output from the current converter 330 at the first node N1 via the third resistor R3.

The current measurement circuit 400 processes the current signal of the first node N1 by adding the offset current to the resonant current Ir. As shown in FIG. 10, the current signal of the first node N1 may be processed into a signal that resonates around the offset current.

The current measurement circuit 400 may further include a fourth resistor R4. The fourth resistor R4 has one end connected to the first node N1 and the other end connected to a second node N2.

The third switch DS3 is connected to and disposed between the second node N2 and the ground voltage terminal. The third switch DS3 is switched according to the resonant voltage Vr. The current signal of the second node N2 is processed according to switching of the third switch DS3. As illustrated in FIG. 11, the current signal of the second node N2 may become zero current when the third switch DS3 is turned on based on the resonant voltage Vr. The signal of the first node N1 may be outputted as the signal of the second node N2 when the third switch DS3 is turned off based on the resonant voltage Vr.

The current measurement circuit 400 may further include a fifth resistor R5. The fifth resistor R5 has one end connected to the second node N2 and the other end connected to a third node N3.

The capacitor C2 has one end connected to the third node N3 and the other end connected to the ground voltage terminal. The capacitor C2 outputs the current signal of the third node N3 as a current signal in the form of a direct current.

As shown in FIG. 12, the current signal of the third node N3 is processed into an average input current Iavg having a level between half of the offset current Offset/2 and the full offset current Offset via the capacitor C2. This average input current Iavg is provided to the controller 500. The controller 500 may measure or calculate the load power currently supplied to the load circuit 350 using the average input current Iavg.

The offset current-based power measurement scheme according to the present embodiment does not prevent the degradation in the reliability of the switches DS1 and DS2 operating at the high frequency of the inverter circuit 320 due to noise via the shunt, does not require the use of the shunt resistor, is robust against noise, and may normally measure the load power even at the high frequency operation and under the duty adjustment .

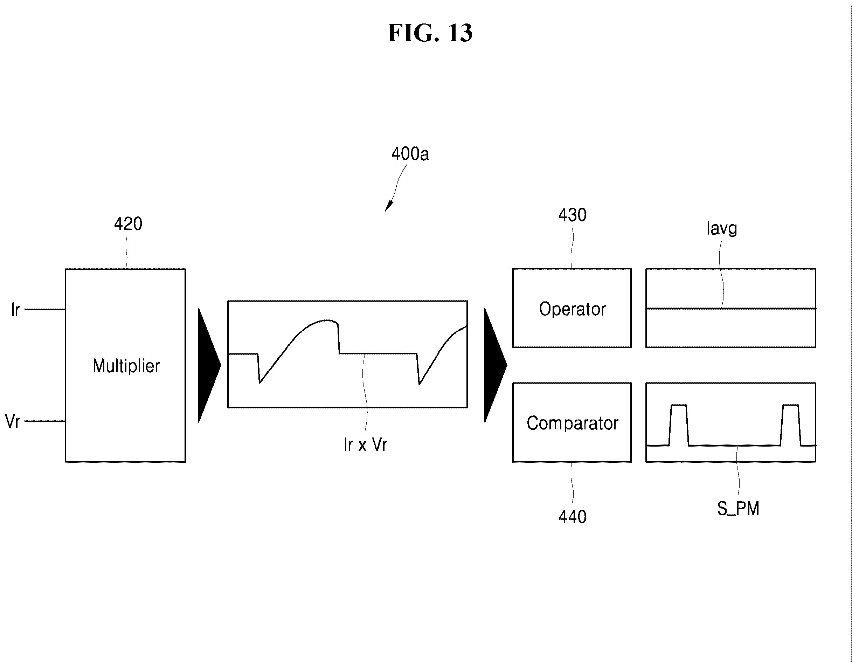

FIG. 13 is a diagram illustrating a current measurement circuit based on a multiplier according to a second embodiment of the present disclosure. FIG. 13 shows a circuit diagram of a circuit for performing a multiplier-based power measurement scheme. This circuit uses the resonant current and the resonant voltage in FIG. 6.

A current measurement circuit based on a multiplier according to the present embodiment may restore the form of the direct current input current by the multiplier performing the multiplication between the resonant current and the resonant voltage, and may average the direct current input current to measure the power to be transmitted to the load.

Specifically, referring to FIG. 13, a multiplier-based current measuring circuit 400a processes the resonant current Ir into the average input current in the form of the direct current using a multiplier 420.

The current measurement circuit 400a includes the multiplier 420, an operator 430, and a comparator 440. The multiplier 420 multiplies the resonant current Ir and the resonant voltage Vr to output an input current Ir x Vr. The input current Ir x Vr may include negative current and phase margin information.

The operator 430 averages the input current and outputs an average direct current input current Iavg. The average input current Iavg in the form of the DC current is provided to the controller 500 and used to measure the load power of the load circuit 350.

The comparator 440 compares the input current Ir x Vr with a reference signal to extract a pulse signal S_PM having the phase margin information. The pulse signal S_PM is provided to the controller 500 and used to control a phase of the driving current.

The advantage of the multiplier-based power measurement scheme according to the present embodiment is that reliability of the switches DS1 and DS2 operating at a high frequency of the inverter circuit 320 is not deteriorated due to noise via the shunt, the use of a shunt resistor is unnecessary, the power measurement is robust against the noise, the power can be normally measured even at the high frequency operation and under the duty adjustment, and information on the phase may also be acquired.

As described above, the present disclosure describes the contents of current transducer (CT) resonant current-based power control that may be used for high frequency all free IH (induction heating) using the silicon carbide (SiC) MOSFET as a wide band gap element in the inverter circuit 320.

In addition, the CT offset current-based measurement scheme and the CT multiplier-based current measurement scheme which may be robust to the noise and can measure the load power using the CT-based resonant current even when the SiC operates have been described above.

The offset current-based measurement scheme takes an average by offsetting the resonant current. The multiplier-based current measurement scheme restores the input current via the multiplication of the resonant voltage and the resonant current and measures the load power based on the averaged restored input current. These schemes may contribute to increasing the operational reliability of the high frequency switching elements of the inverter circuit.

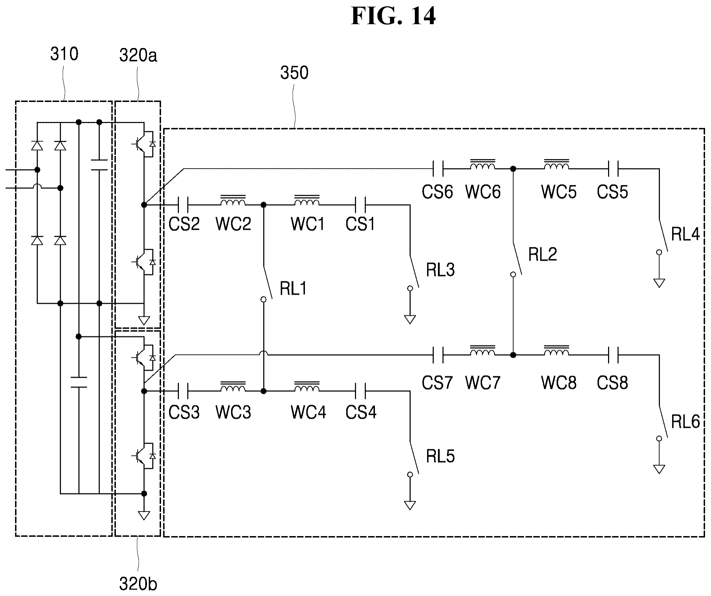

FIG. 14 is a diagram illustrating a driving circuit and a load circuit in a cooking appliance according to an embodiment of the present disclosure.

Referring to FIG. 14, in the cooking appliance according to an embodiment, the driving circuit includes the rectifier circuit 310 and an inverter circuit 320a and 320b.

The inverter circuit 320a and 320b include a first inverter circuit 320a configured to supply a first driving current to the load circuit 350 according to the switching operation and a second inverter circuit 320b configured to supply a second driving current to the load circuit 350 according to the switching operation.

The load circuit 350 may include at least one capacitor CS1, CS2, CS3, CS4, CS5, CS6, CS7, and CS8, at least one heating coil WC1, WC2, WC3, WC4, WC5, WC6, WC7, and WC8, and at least one relay RL1, RL2, RL3, RL4, and RL4RL6 connected in series or in parallel with each other.

The capacitors CS1, CS2, CS3, CS4, CS5, CS6, CS7, and CS8 may be used to filter a DC component from the driving current. The heating coils WC1, WC2, WC3, WC4, WC5, WC6, WC7, and WC8 may be used to heat the cooking container using electromagnetic induction. The relays RL1, RL2, RL3, RL4, RL4, and RL6 may be used to selectively connect the heating coils WC1, WC2, WC3, WC4, WC5, WC6, WC7, and WC8 to each other in a series or parallel manner to each other. In addition, the heating coils WC1, WC2, WC3, WC4, WC5, WC6, WC7, and WC8 and the capacitors CS1, CS2, CS3, CS4, CS5, CS6, CS7, and CS8 may be used to determine the resonance frequency of the driving current.

The load circuit 350 may include a first capacitor CS1 configured to transmit the first driving current supplied from the first inverter circuit 320a, a first heating coil WC1 connected in series to the first capacitor CS1, a second heating coil WC2 connected in series to the first heating coil WC1, a second capacitor CS2 connected in series to the second heating coil WC2, and a first relay RL1 configured to switch the second capacitor CS2 and a ground voltage terminal.

In addition, the load circuit 350 may further include a third capacitor CS3 configured to transmit the second driving current supplied from the second inverter circuit 320b, a third heating coil WC3 connected in series to the third capacitor CS3, a fourth heating coil WC4 connected in series to the third heating coil WC3, a fourth capacitor CS4 connected in series to the fourth heating coil WC4, and a second relay RL2 configured to switch the fourth capacitor CS4 and the ground voltage terminal.

In addition, the load circuit 350 may further include a third relay RL3 configured to switch a node between the first heating coil WC1 and the second heating coil WC2 and a node between the third heating coil WC3 and the fourth heating coil WC4.

In addition, the load circuit 350 may further include a fifth capacitor CS5 configured to transmit the first driving current supplied from the first inverter circuit 320a, a fifth heating coil WC5 connected in series to the fifth capacitor CS5, a sixth heating coil WC6 connected in series to the fifth heating coil WC5, a sixth capacitor CS6 connected in series to the sixth heating coil WC6, and a fourth relay RL4 configured to switch the sixth capacitor CS6 and the ground voltage terminal.

In addition, the load circuit 350 may further include a seventh capacitor CS7 configured to transmit the second driving current supplied from the second inverter circuit 320b, a seventh heating coil WC7 connected in series to the seventh capacitor WC7, an eighth heating coil WC8 connected in series to the seventh heating coil CS7, an eighth capacitor CS8 connected in series to the eighth heating coil WC7, and a fifth relay RL5 configured to switch the eighth capacitor CS8 and the ground voltage terminal.

In addition, the load circuit 350 may further include a sixth relay RL6 configured to switch a node between the fifth heating coil WC5 and the sixth heating coil WC6 and a node between the seventh heating coil WC7 and the eighth heating coil WC8.

A cooking appliance according to an embodiment of the present disclosure may include a heating coil for heating a container using electromagnetic induction; a driving circuit configured to supply a driving current to the heating coil according to switching operation thereof, and to output a resonant current obtained via current conversion of the driving current, and a resonant voltage based on the driving current; a current measurement circuit configured to measure an average input current of the heating coil using the resonant current and the resonant voltage; and a controller configured to measure power of the heating coil using the average input current, determine a switching frequency of the driving circuit based on the measured power, and control the switching operation based on the switching frequency.

In accordance with one embodiment, the driving circuit may include: an inverter circuit configured to supply the driving current to the heating coil according to the switching operation thereof; a current converter configured to output a resonant current based on the driving current output from the inverter circuit; and a resonant voltage generator configured to output the resonant voltage based on the driving current output from the inverter circuit.

In accordance with one embodiment, the inverter circuit may include: a first switch and a second switch connected in series with each other and disposed between and connected to a high potential terminal and a low potential terminal; and an output line connected to a node between the first switch and the second switch.

In accordance with one embodiment, the current converter may be disposed adjacent to the output line and may be configured to convert the driving current into the resonant current having a magnitude proportional to a magnitude of the driving current.

In accordance with one embodiment, the resonant voltage generator may include a first output resistor and a second output resistor connected in series to each other and disposed between and connected to the output line and the low potential terminal, wherein the resonant voltage generator may be configured to output the resonant voltage via a node between the first output resistor and the second output resistor, wherein the output resonant voltage may be in a form of a square wave based on the driving current.

In accordance with one embodiment, the current measurement circuit may be configured to process the resonant current of the current converter into the average input current of a direct current form using an offset current.

In accordance with one embodiment, the current measurement circuit may include: an offset circuit including a first resistor and a second resistor connected in series with each other and disposed between and connected to a power voltage terminal and a ground voltage terminal, wherein the offset circuit may be configured to output the offset current via a node between the first resistor and the second resistor; a third resistor connected in parallel to the current converter, wherein the third resistor has one end connected to the node between the first resistor and the second resistor and the current converter, and the other end connected to a first node connected to the current converter; a fourth resistor having one end connected to the first node and the other end connected to a second node; a third switch connected to and disposed between the second node and the ground voltage terminal and configured to switch according to the resonant voltage; and a fifth resistor having one end connected to the second node and the other end connected to a third node; and a capacitor having one end connected to the third node and the other end connected to the ground voltage terminal.

In accordance with one embodiment, the current measurement circuit may be configured to: add the offset current to the resonant current to process a current signal of the first node; process a current signal of the second node according to switching of the third switch; process a current signal of the third node into the average input current using the capacitor; and provide the average input current to the controller.

In accordance with one embodiment, the current measurement circuit may be configured to process the resonant current of the current converter into the average input current of a direct current form using a multiplier.

In accordance with one embodiment, the current measurement circuit may include: a multiplier configured to perform multiplication between the resonant current and the resonant voltage to output an input current including a negative current and phase margin information; an operator configured to average the input current to output the average input current; and a comparator configured to compare the input current with a reference signal to extract a pulse signal having the phase margin information and to provide the pulse signal to the controller.

A cooking appliance in accordance with one embodiment of the present disclosure may include a load circuit including a heating coil; an inverter circuit configured to supply a driving current to the load circuit according to switching operation thereof; a current converter configured to perform current conversion of the driving current to output a resonant current; a resonant voltage generator configured to output a resonant voltage based on the driving current; a current measurement circuit configured to measure an average input current of the load circuit using the resonant current and the resonant voltage; and a controller configured to measure power of the load circuit using the average input current, determine a switching frequency of the driving circuit based on the measured power, and control the switching operation based on the switching frequency.

In accordance with one embodiment, the inverter circuit may include a first inverter circuit and a second inverter circuit configured to respectively supply a first driving current and a second driving current to the load circuit according to the switching operation thereof.

In accordance with one embodiment, the current converter may include: a first current converter configured to output a first resonant current based on the first driving current output from the first inverter circuit; and a second current converter configured to output a second resonant current based on the second driving current output from the second inverter circuit.

In accordance with one embodiment, the resonant voltage generator may include: a first resonant voltage generator configured to output a first resonant voltage based on the first driving current from the first inverter circuit; and a second resonant voltage generator configured to output a second resonant voltage based on the second driving current from the second inverter circuit.

In accordance with one embodiment, the current measurement circuit may be configured to process the first resonant current from the first current converter or the second resonant current from the second current converter into the average input current of a direct current form using a preset offset current and the resonant voltage.

In accordance with one embodiment, the current measuring circuit may be configured to process the first resonant current from the first current converter or the second resonant current from the second current converter into the average input current of a direct current form using a multiplier, wherein the multiplier may be configured to perform multiplication between the resonant current and the resonant voltage.

In accordance with one embodiment, the load circuit may include at least one capacitor, at least one heating coil, and at least one relay connected in series or in parallel with each other.

In accordance with one embodiment, the load circuit may include: a first capacitor configured to transmit a first driving current supplied from a first inverter circuit of the driving circuit; a first heating coil connected in series to the first capacitor; a second heating coil connected in series to the first heating coil; a second capacitor connected in series to the second heating coil; and a first relay configured to switch the second capacitor and a ground voltage terminal.

In accordance with one embodiment, the load circuit may further include: a third capacitor configured to transmit a second driving current supplied from a second inverter circuit of the driving circuit; a third heating coil connected in series to the third capacitor; a fourth heating coil connected in series to the third heating coil; a fourth capacitor connected in series to the fourth heating coil; and a second relay configured to switch the fourth capacitor and the ground voltage terminal.

In accordance with one embodiment, the load circuit may further include a third relay configured to switch a node between the first heating coil and the second heating coil and a node between the third heating coil and the fourth heating coil.

In accordance with one embodiment, the load circuit may further include: a fifth capacitor configured to transmit the first driving current supplied from the first inverter circuit of the driving circuit; a fifth heating coil connected in series to the fifth capacitor; a sixth heating coil connected in series to the fifth heating coil; a sixth capacitor connected in series to the sixth heating coil; and a fourth relay configured to switch the sixth capacitor and the ground voltage terminal.

In accordance with one embodiment, the load circuit may further include: a seventh capacitor configured to transmit the second driving current supplied from the second inverter circuit of the driving circuit; a seventh heating coil connected in series to the seventh capacitor; an eighth heating coil connected in series to the seventh heating coil; an eighth capacitor connected in series to the eighth heating coil; and a fifth relay configured to switch the eighth capacitor and the ground voltage terminal.

In accordance with one embodiment, the load circuit may further include a sixth relay configured to switch a node between the fifth heating coil and the sixth heating coil and a node between the seventh heating coil and the eighth heating coil.

Although the present disclosure has been described above with reference to the embodiments illustrated in the drawings, this is merely an example, and those skilled in the art will understand that various modifications and other equivalent embodiments may be derived therefrom. Accordingly, the true technical protection scope of the present disclosure should be determined by the following claims.

## Claims

1. A cooking appliance comprising:
a heating coil for heating a container using electromagnetic induction;
a driving circuit configured to supply a driving current to the heating coil according to switching operation thereof, and to output a resonant current obtained via current conversion of the driving current, and a resonant voltage based on the driving current;
a current measurement circuit configured to measure an average input current of the heating coil using the resonant current and the resonant voltage; and
a controller configured to measure power of the heating coil using the average input current, determine a switching frequency of the driving circuit based on the measured power, and control the switching operation based on the switching frequency.

2. The cooking appliance of claim 1, wherein the driving circuit includes:
an inverter circuit configured to supply the driving current to the heating coil according to the switching operation thereof;
a current converter configured to output a resonant current based on the driving current output from the inverter circuit; and
a resonant voltage generator configured to output the resonant voltage based on the driving current output from the inverter circuit.

3. The cooking appliance of claim 2, wherein the inverter circuit includes:
a first switch and a second switch connected in series with each other and disposed between and connected to a high potential terminal and a low potential terminal; and
an output line connected to a node between the first switch and the second switch.

4. The cooking appliance of claim 3, wherein the current converter is disposed adjacent to the output line and is configured to convert the driving current into the resonant current having a magnitude proportional to a magnitude of the driving current.

5. The cooking appliance of claim 4, wherein the resonant voltage generator includes a first output resistor and a second output resistor connected in series to each other and disposed between and connected to the output line and the low potential terminal,
wherein the resonant voltage generator is configured to output the resonant voltage via a node between the first output resistor and the second output resistor, wherein the output resonant voltage is in a form of a square wave based on the driving current.

6. The cooking appliance of claim 2, wherein the current measurement circuit is configured to process the resonant current of the current converter into the average input current of a direct current form using an offset current.

7. The cooking appliance of claim 6, wherein the current measurement circuit includes:
an offset circuit including a first resistor and a second resistor connected in series with each other and disposed between and connected to a power voltage terminal and a ground voltage terminal, wherein the offset circuit is configured to output the offset current via a node between the first resistor and the second resistor;
a third resistor connected in parallel to the current converter, wherein the third resistor has one end connected to the node between the first resistor and the second resistor and the current converter, and the other end connected to a first node connected to the current converter;
a fourth resistor having one end connected to the first node and the other end connected to a second node;
a third switch connected to and disposed between the second node and the ground voltage terminal and configured to switch according to the resonant voltage; and
a fifth resistor having one end connected to the second node and the other end connected to a third node; and
a capacitor having one end connected to the third node and the other end connected to the ground voltage terminal.

8. The cooking appliance of claim 7, wherein the current measurement circuit is configured to:
add the offset current to the resonant current to process a current signal of the first node;
process a current signal of the second node according to switching of the third switch;
process a current signal of the third node into the average input current using the capacitor; and
provide the average input current to the controller.

9. The cooking appliance of claim 2, wherein the current measurement circuit is configured to process the resonant current of the current converter into the average input current of a direct current form using a multiplier.

10. The cooking appliance of claim 9, wherein the current measurement circuit includes:
a multiplier configured to perform multiplication between the resonant current and the resonant voltage to output an input current including a negative current and phase margin information;
an operator configured to average the input current to output the average input current; and
a comparator configured to compare the input current with a reference signal to extract a pulse signal having the phase margin information and to provide the pulse signal to the controller.

11. A cooking appliance comprising:
a load circuit including a heating coil;
an inverter circuit configured to supply a driving current to the load circuit according to switching operation thereof;
a current converter configured to perform current conversion of the driving current to output a resonant current;
a resonant voltage generator configured to output a resonant voltage based on the driving current;
a current measurement circuit configured to measure an average input current of the load circuit using the resonant current and the resonant voltage; and
a controller configured to measure power of the load circuit using the average input current, determine a switching frequency of the driving circuit based on the measured power, and control the switching operation based on the switching frequency.

12. The cooking appliance of claim 11, wherein the inverter circuit includes a first inverter circuit and a second inverter circuit configured to respectively supply a first driving current and a second driving current to the load circuit according to the switching operation thereof.

13. The cooking appliance of claim 12, wherein the current converter includes:
a first current converter configured to output a first resonant current based on the first driving current output from the first inverter circuit; and
a second current converter configured to output a second resonant current based on the second driving current output from the second inverter circuit.

14. The cooking appliance of claim 13, wherein the resonant voltage generator includes:
a first resonant voltage generator configured to output a first resonant voltage based on the first driving current from the first inverter circuit; and
a second resonant voltage generator configured to output a second resonant voltage based on the second driving current from the second inverter circuit.

15. The cooking appliance of claim 14, wherein the current measurement circuit is configured to process the first resonant current from the first current converter or the second resonant current from the second current converter into the average input current of a direct current form using a preset offset current and the resonant voltage.

16. The cooking appliance of claim 15, wherein the current measuring circuit is configured to process the first resonant current from the first current converter or the second resonant current from the second current converter into the average input current of a direct current form using a multiplier, wherein the multiplier is configured to perform multiplication between the resonant current and the resonant voltage.

17. The cooking appliance of claim 11, wherein the load circuit includes at least one capacitor, at least one heating coil, and at least one relay connected in series or in parallel with each other.

18. The cooking appliance of claim 11, wherein the load circuit includes:
a first capacitor configured to transmit a first driving current supplied from a first inverter circuit of the driving circuit;
a first heating coil connected in series to the first capacitor;
a second heating coil connected in series to the first heating coil;
a second capacitor connected in series to the second heating coil; and
a first relay configured to switch the second capacitor and a ground voltage terminal,
wherein the load circuit further includes:
a third capacitor configured to transmit a second driving current supplied from a second inverter circuit of the driving circuit;
a third heating coil connected in series to the third capacitor;
a fourth heating coil connected in series to the third heating coil;
a fourth capacitor connected in series to the fourth heating coil; and
a second relay configured to switch the fourth capacitor and the ground voltage terminal, wherein the load circuit further includes a third relay configured to switch a node between the first heating coil and the second heating coil and a node between the third heating coil and the fourth heating coil.

19. The cooking appliance of claim 18, wherein the load circuit further includes:
a fifth capacitor configured to transmit the first driving current supplied from the first inverter circuit of the driving circuit;
a fifth heating coil connected in series to the fifth capacitor;
a sixth heating coil connected in series to the fifth heating coil;
a sixth capacitor connected in series to the sixth heating coil; and
a fourth relay configured to switch the sixth capacitor and the ground voltage terminal,
wherein the load circuit further includes:
a seventh capacitor configured to transmit the second driving current supplied from the second inverter circuit of the driving circuit;
a seventh heating coil connected in series to the seventh capacitor;
an eighth heating coil connected in series to the seventh heating coil;
an eighth capacitor connected in series to the eighth heating coil; and
a fifth relay configured to switch the eighth capacitor and the ground voltage terminal.

20. The cooking appliance of claim 19, wherein the load circuit further includes a sixth relay configured to switch a node between the fifth heating coil and the sixth heating coil and a node between the seventh heating coil and the eighth heating coil.
